# EUROPÄISCHE PATENTSCHRIFT

(11) **EP 1 296 886 B1**
(45) Veröffentlichungstag und Bekanntmachung des Hinweises auf die Patenterteilung: **08.10.2008**
(21) Anmeldenummer: 01921222.4
(22) Anmeldetag: 21.03.2001
(51) Int. Cl.: B81B 1/00

(54) **HERSTELLUNGSVERFAHREN FÜR EIN MIKROMECHANISCHES BAUELEMENT**
METHOD FOR PRODUCING A MICROMECHANICAL COMPONENT
PROCEDE DE PRODUCTION D'UN COMPOSANT MICROMECANIQUE

(30) Priorität: 18.05.2000 DE 10024697
(43) Veröffentlichungstag der Anmeldung: 02.04.2003
(73) Patentinhaber: ROBERT BOSCH GMBH, 70442 Stuttgart (DE)
(72) Erfinder: LUTZ, Markus, Sunnyvale, CA 94086 (US)
(86) Internationale Anmeldenummer: PCT/DE2001/001073
(87) Internationale Veröffentlichungsnummer: WO 2001/087765

(56) Entgegenhaltungen:
- WO-A-01/77009
- DE-A- 4 332 843
- DE-A- 10 017 422
- DE-A- 19 537 814
- KNIFFIN M L ET AL: "PACKAGING FOR SILICON MICROMACHINED ACCELEROMETERS" INTERNATIONAL JOURNAL OF MICROCIRCUITS AND ELECTRONIC PACKAGING, INTERNATIONAL MICROELECTRONICS & PACKAGING SOCIETY, US, Bd. 19, Nr. 1, 1996, Seiten 75-86, XP000639470 ISSN: 1063-1674

## Beschreibung

### STAND DER TECHNIK

Die vorliegende Erfindung betrifft ein Verfahren zur Herstellung eines mikromechanischen Bauelementes mit den Schritten: Bereitstellen eines Substrats; Vorsehen einer ersten mikromechanischen Funktionsschicht auf dem Substrat; Strukturieren der ersten mikromechanischen Funktionsschicht derart, dass sie eine beweglich zu machende Sensorstruktur aufweist; Vorsehen und Strukturieren einer ersten Verschlussschicht auf der strukturierten ersten mikromechanischen Funktionsschicht auf der ersten Verschlussschicht; Vorsehen und Strukturieren einer zweiten mikromechanischen Funktionsschicht auf der ersten Verschlussschicht, welche zumindest eine Abdeckfunktion aufweist und zumindest teilweise in der ersten mikromechanischen Funktionsschicht verankert wird; Beweglichmachen der Sensorstruktur; und Vorsehen einer zweiten Verschlussschicht auf der zweiten mikromechanischen Funktionsschicht. Ein derartiges Verfahren bzw. ein derartiges mikromechanisches Bauelement sind aus der älteren deutschen Patentanmeldung 100 17 422.1 bzw. der EP 0191984.0 bekannt.

Aus der DE 43 32 843 A1 sind eine mikromechanische Vorrichtung und ein Verfahren zu deren Herstellung bekannt, wobei ein Körper gebildet wird, bei dem auf einem Träger eine erste Isolierschicht und darüber eine Siliziumschicht angeordnet ist. Die Siliziumschicht wird strukturiert, wobei Öffnungen bis auf die erste Isolierschicht gebildet werden. Eine Isolieschichtzone und eine weitere flächige Schicht werden aufgetragen, die weitere flächige Schicht wird strukturiert, wobei Öffnungen bis auf die Isolierschichtzone gebildet werden. Die Isolierschichtzone und die darunterliegenden Bereiche der ersten Isolierschicht werden selektiv geätzt, und über der weiteren flächigen Schicht wird eine zweite Isolierschicht als Abdeckung aufgetragen.

Aus Kniffin M L et al., "PACKAGING FOR SILICON MICROMACHINED ACCELEROMETERS" INTERNATIONAL JOURNAL OF MICROCIRCUITS AND ELECTRONIC PACKAGING, INTERNATIONAL MICROELECTRONICS & PACKAGING SOCIETY, US, Bd. 19, Nr. 1, 1996, Seiten 75-86, ist es bekannt, dünne Filme, welche durch chemische Dampfphasenabscheidung hergestellt werden, zu Mikroverkapselung von oberflächenmikromechanischen Vorrichtungen zu verwenden.

Obwohl auf beliebige mikromechanische Bauelemente und Strukturen, insbesondere Sensoren und Aktuatoren, anwendbar, werden die vorliegende Erfindung sowie die ihr zugrundeliegende Problematik in bezug auf ein in der Technologie der Silizium-Oberflächenmikromechanik herstellbares mikromechanisches Bauelement, z.B. einen Beschleunigungssensor, erläutert.

Allgemein bekannt sind monolithisch integrierte inertiale Sensoren in Oberflächenmikromechanik (OMM), bei denen die empfindlichen beweglichen Strukturen ungeschützt auf dem Chip aufgebracht sind (Analog Devices). Dadurch entsteht ein erhöhter Aufwand beim Handling und bei der Verpackung.

Umgehen kann man dieses Problem durch einen Sensor, wobei die OMM-Strukturen mittels einem zweiten Kappenwafer abgedeckt sind. Diese Art der Verpackung verursacht einen hohen Anteil (ca. 75%) der Kosten eines OMM-Beschleunigungssensors. Diese Kosten entstehen durch den hohen Flächenbedarf der Dichtfläche zwischen Kappenwafer und Sensorwafer und aufgrund der aufwendigen Strukturierung (2-3 Masken, Bulkmikromechanik) des Kappenwafers.

In der DE 195 37 814 A1 werden der Aufbau eines funktionalen Schichtsystems und ein Verfahren zur hermetischen Verkappung von Sensoren in Oberflächenmikromechanik beschrieben. Hierbei wird die Herstellung der Sensorstruktur mit bekannten technologischen Verfahren erläutert. Die besagte hermetische Verkappung erfolgt mit einem separaten Kappen-Wafer aus Silizium, der mit aufwendigen Strukturierungsprozessen, wie beispielsweise KOH-Ätzen, strukturiert wird. Der Kappen-Wafer wird mit einem Glas-Lot (Seal-Glas) auf dem Substrat mit dem Sensor (Sensor-Wafer) aufgebracht. Hierfür ist um jeden Sensorchip ein breiter Bond-Rahmen notwendig, um eine ausreichende Haftung und Dichtheit der Kappe zu gewährleisten. Dies begrenzt die Anzahl der Sensor-Chips pro Sensor-Wafer erheblich. Auf Grund des großen Platzbedarfs und der aufwendigen Herstellung des KappenWafers entfallen erhebliche Kosten auf die Sensor-Verkappung.

Das in der älteren deutschen Patentanmeldung 100 17 422.1 offenbarte Herstellungsverfahren bzw. Bauelement bauen auf einen bekannten OMM-Prozeß auf, der Epitaxie-Polysilizium mit mindestens 10 µm Dicke zur Bildung einer mikromechanischen Funktionsschicht schafft. Es wird keine neue permeable Schicht benötigt, sondern man verwendet an sich bekannte Prozesse. Neu ist lediglich der Schritt zur Erzeugung der Verschlußschichten, welche eine Abdicht- und Einebenungsfunktion haben.

Es ergibt sich eine Vereinfachung des OMM-Prozesses, da aufgrund der zweiten mikromechanischen Funktionsschicht, die zumindest eine Abdeckfunktion übernimmt, der Kappenwafer entfällt und die Strukturen von oben kontaktiert werden können.

Weiterhin gewinnt der Prozeß an Funktionalität, d.h. dem Designer stehen weitere mechanische und/oder elektrische Bauelemente zur Realisierung des Bauelementes Verfügung. Insbesondere können folgende Funktionselemente erstellt werden:
- eine Drucksensormembran in der zweiten mikromechanischen Funktionsschicht;
- eine Leiterbahnstruktur in der zweiten mikromechanischen Funktionsschicht, welche sich mit einer oberhalb der zweiten Verschlußschicht vorgesehenen weiteren Leiterbahnstruktur überkreuzen kann;
- sehr niederohmige Zuleitungen aus Aluminium in der oberhalb der zweiten Verschlußschicht vorgesehenen weiteren Leiterbahnstruktur;
- ein vertikaler Differentialkondensator;
- weitere Verankerungen der Strukturen der ersten mikromechanischen Funktionsschicht in der zweiten mikromechanischen Funktionsschicht.

Auch können übliche IC-Verpackungen, wie Hybrid, Kunststoff, Flip-Chip etc., verwendet werden.

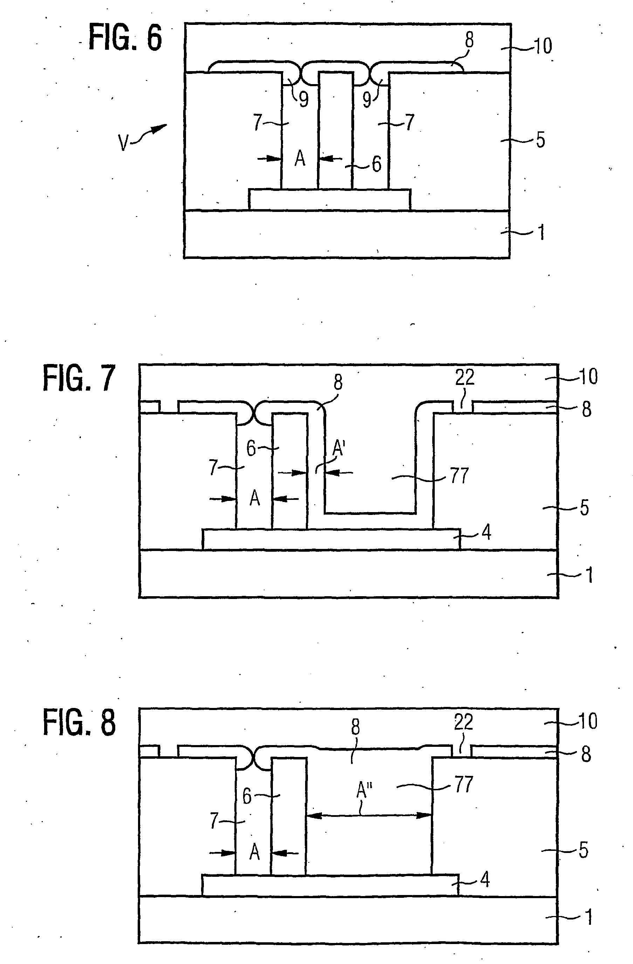

Fig. 6 zeigt einen Ausschnitt V eines mikromechanischen Bauelements zur Erläuterung der der vorliegenden Erfindung zugrundeliegenden Problematik.

In Fig. 6 bezeichnen 1 einen Silizium-Substratwafer, 4 ein Opferoxid, 5 eine erste mikromechanische Funktionsschicht in Form einer Epitaxie-Polysiliziumschicht, 6 eine später durch Ätzen der Opferschicht 4 und der Schicht 8 beweglich zu machende Sensorstruktur (Kammstruktur), 7 Gräben in der ersten mikromechanischen Funktionsschicht 5, 8 ein erstes Verschlußoxid (LTO, TEOS o.ä.) - auch als Refillschicht bezeichnet -, 9 Pfropfen in den Gräben 7 bestehend aus dem Verschlußoxid 8 und 10 eine zweite mikromechanische Funktionsschicht mit einer Abdeckfunktion in Form einer Epitaxie-Polysiliziumschicht.

Im Refillprozeß zur Abscheidung der Schicht 8 werden die Gräben 7 der beweglich zu machenden Sensorstruktur 6 aufgefüllt bzw., wie gezeigt, nur an ihrer Oberseite verpfropft, damit eine planare Oberfläche entsteht, auf der dann die zweite mikromechanische Funktionsschicht 10 mit der Abdeckfunktion zum Beispiel als Epitaxi-Polysilizium aufgebracht wird. Insbesondere bei Sensorstrukturen 6 mit hohem Aspektverhältnis, welche aus dem besagten Oberflächenmikromechanik-Epitaxi-Polysilizium hergestellt werden, ist es sehr schwierig, die tiefen Gräben 7 aufzufüllen, weshalb man, wie gezeigt, nur die Oberfläche des Wafers bedeckt und die Gräben 7 nur oben abschließt bzw. mit Pfropfen 9 verpfropft.

Dieser Refillprozess kann z.B. nur Gräben 7 bis zu einer Breite von ca. 5 µm verschließen bzw. abdichten, ohne dass viel Oxid am Boden des Grabens 7 abgeschieden wird. Aus dieser maximalen Breite A ergibt sich die maximal mögliche Schwingungsamplitude der betreffenden beweglichen Sensorstruktur 6, welche beispielsweise einen Drehratensensor bildet.

Fig. 7 zeigt eine Modifikation des Ausschnitts von Fig. 6 zur Erläuterung der der vorliegenden Erfindung zugrundeliegenden Problematik.

Würde man bei dem mit Bezug auf Fig. 6 beschriebenen Refillprozess breitere Gräben 77 (z.B. mit einer Breite von 15 µm) abdecken, so würde eine bewegliche Sensorstruktur 6 in ihrer maximal möglichen Auslenkung A' weiter eingeschränkt, nämlich auf die Dicke des Refillmaterials 8 an der Seitenwand der beweglichen Sensorstruktur 6 (nach Entfernen des Refillmaterials 8).

Fig. 8 zeigt eine weitere Modifikation des Ausschnitts von Fig. 6 zur Erläuterung der der vorliegenden Erfindung zugrundeliegenden Problematik.

Im Zusammenhang mit Fig. 8 sei bemerkt, dass diese aus Gründen der Übersichtlichkeit die Abscheidung des Refillmaterials 8 an der Oberfläche nicht maßstabsgetreu zeigt.

Damit die maximale Auslenkung A" der beweglichen Sensorstruktur 6 genauso groß wie der breitere Graben 77 würde, müsste der breitere Graben 77 vollständig mit dem Refillmaterial 8 aufgefüllt werden, damit das Abdeck-Polysilizium 10 nur oberhalb der Sensorstruktur 6 abgeschieden wird. Dadurch entstünden folgende Nachteile der Prozessführung:
- ein langer Abscheideprozess des Refillmaterials 8;
- eine notwendige zusätzliche Planarisierung des Refillmaterials 8, da hohe Stufen entstehen und keine genaue Lithographie mehr möglich ist, welche z. B. für die Kontaktlöcher 22 notwendig ist; und
- ein langer aufwendiger Prozess zum Entfernen des Refillmaterials.

Die der vorliegenden Erfindung zugrundeliegende Problematik besteht somit allgemein darin, bewegliche Sensorstrukturen trotz des Refillprozesses und ohne Prozessmodifikationen mit großen maximalen Schwingungsamplituden zu realisieren.

### VORTEILE DER ERFINDUNG

Das erfindungsgemäße Herstellungsverfahren mit den Merkmalen des Anspruchs 1 weist den Vorteil auf, dass stets die maximal mögliche Auslenkamplitude für die bewegliche Sensorstruktur erreichbar ist.

In den abhängigen Ansprüchen finden sich vorteilhafte Weiterbildungen und Verbesserungen des jeweiligen Gegenstandes der Erfindung.

Gemäß einer bevorzugten Weiterbildung wird eine Kammstruktur mit ineinandergreifenden Kammzinken in der Sensorstruktur vorgesehen, wobei die Summe der Breite eines Kammzinkens und zweier Abstände zum nächst benachbarten Kammzinken kleiner oder gleich der maximalen Grabenbreite ausgelegt wird.

Gemäß einer bevorzugten Weiterbildung wird eine gefaltete Biegefederstruktur in der Sensorstruktur vorgesehen, wobei der Abstand der Faltungen gleich der maximalen Grabenbreite ausgelegt wird, so daß die maximale Schwingungsamplitude gleich der Anzahl der Faltungen mal der maximalen Grabenbreite beträgt.

Gemäß einer weiteren bevorzugten Weiterbildung wird eine Opferschicht auf dem Substrat vorgesehen und die Opferschicht zum Beweglichmachen der Sensorstruktur geätzt. Bei einer vereinfachten Version kann das Substrat mit einer Opferschicht und der ersten mikromechanischen Funktionsschicht als SOI(Silicon on Insulator)-Struktur vorgesehen werden.

Gemäß einer weiteren bevorzugten Weiterbildung erfolgt ein Strukturieren der ersten mikromechanischen Funktionsschicht derart, daß sie bis zur Operschicht reichende erste Durchgänge aufweist. Weiterhin erfolgt ein Strukturieren der zweiten mikromechanischen Funktionsschicht derart, daß sie bis zur ersten Verschlußschicht reichende zweite Durchgänge aufweist, welche durch Verbindungsbereiche der ersten Verschlußschicht mit den ersten Durchgängen verbunden sind. Danach erfolgt ein Ätzen der ersten Verschlußschicht zum Entfernen der Verbindungsbereiche unter Verwendung der zweiten Durchgänge als Ätzkanäle. Schließlich erfolgt ein Ätzen der Opferschicht unter Verwendung der durch das Entfernen der Verbindungsbereiche miteinander verbundenen ersten und zweiten Durchgänge als Ätzkanäle. Dies minimiert den Aufwand für die Ätzprozesse, da die Opferschicht und die erste Verschlußschicht in einem Prozeß geätzt werden können.

Für das Entfernen der optionellerweise vorgesehenen Opferschicht werden also durch die erste und zweite mikromechanische Funktionsschicht und die dazwischenliegende erste Verschlußschicht laufende Ätzkanäle erzeugt. Dadurch kann die Dicke der zweiten mikromechanischen Funktionsschicht erhöht sein und deren Festigkeit bzw. Steifigkeit verbessert sein. Demzufolge können größere Flächen überspannt werden und die Bauelemente höherem Streß ausgesetzt werden. Beim Entfernen der Opferschicht muß man keine Rücksicht auf Leiterbahn-Aluminium o.ä. nehmen, da es erst zu einem späteren Zeitpunkt aufgebracht wird.

Gemäß einer weiteren bevorzugten Weiterbildung wird eine vergrabene Polysiliziumschicht unterhalb der ersten oder zweiten mikromechanischen Funktionsschicht vorgesehen. Ein Entfallen des vergrabenen Polysiliziums und einer darunterliegenden Isolationsschicht ist ebenfalls möglich, da weitere Verdrahtungsebenen oberhalb der Sensorstruktur verfügbar sind.

Gemäß einer weiteren bevorzugten Weiterbildung werden die erste und zweite Verschlußschicht wesentlich dünner als die erste und zweite mikromechanische Funktionsschicht gestaltet.

Gemäß einer weiteren bevorzugten Weiterbildung werden die erste und/oder zweite Verschlußschicht durch eine nicht-konforme Abscheidung derart vorgesehen, daß die ersten bzw. zweiten Durchgänge nur im oberen Bereich verpropft werden. Dies reduziert die Ätzzeit beim Opferschichtentfernen, da nur ein Teil der Durchgänge verstopft ist.

Gemäß einer weiteren bevorzugten Weiterbildung werden die ersten und/oder zweiten Durchgänge als Gräben oder Löcher gestaltet, die sich nach oben hin verengen.

Gemäß einer weiteren bevorzugten Weiterbildung werden die erste und/oder zweite mikromechanische Funktionsschicht aus einem leitenden Material, vorzugsweise Polysilizium, hergestellt.

Gemäß einer weiteren bevorzugten Weiterbildung werden die erste und/oder zweite Verschlussschicht aus einem dielektrischen Material, vorzugsweise Siliziumdioxid, hergestellt.

Gemäß einer weiteren bevorzugten Weiterbildung werden auf der zweiten Verschlussschicht eine oder mehrere Leiterbahnschichten, vorzugsweise aus Aluminium, vorgesehen.

Gemäß einer weiteren bevorzugten Weiterbildung wird in die zweite mikromechanische Funktionsschicht eine Leiterbahnstruktur integriert.

### ZEICHNUNGEN

Ausführungsbeispiele der Erfindung sind in den Zeichnungen dargestellt und in der nachfolgenden Beschreibung näher erläutert.

Es zeigen:
Fig. 1 eine schematische Oberansicht der ersten mikromechanischen Funktionsschicht zur Erläuterung eines Herstellungsverfahrens eines mikromechanischen Bauelements gemäß einer ersten Ausführungsform der vorliegenden Erfindung;
Fig. 2 eine schematische Querschnittsansicht zur Erläuterung des Herstellungsverfahrens eines mikromechanischen Bauelements gemäß der ersten Ausführungsform der vorliegenden Erfindung in einem ersten Prozessstadium;
Fig. 3 eine schematische Querschnittsansicht zur Erläuterung des Herstellungsverfahrens des mikromechanischen Bauelements gemäß der ersten Ausführungsform der vorliegenden Erfindung in einem zweiten Prozessstadium;
Fig. 4 eine schematische Querschnittsansicht zur Erläuterung des Herstellungsverfahrens des mikromechanischen Bauelements gemäß der ersten Ausführungsform der vorliegenden Erfindung in einem dritten Prozessstadium;
Fig. 5 eine schematische Querschnittsansicht zur Erläuterung des Herstellungsverfahrens des mikromechanischen Bauelements gemäß der ersten Ausführungsform der vorliegenden Erfindung in einem vierten Prozessstadium;
Fig. 6 einen Ausschnitt V eines mikromechanischen Bauelements zur Erläuterung der der vorliegenden Erfindung zugrundeliegenden Problematik;
Fig. 7 eine Modifikation des Ausschnitts von Fig. 6 zur Erläuterung der der vorliegenden Erfindung zugrundeliegenden Problematik; und
Fig. 8 eine weitere Modifikation des Ausschnitts von Fig. 6 zur Erläuterung der der vorliegenden Erfindung zugrundeliegenden Problematik.

### BESCHREIBUNG DER AUSFÜHRUNGSBEISPIELE

In den Figuren bezeichnen gleiche Bezugszeichen gleiche oder funktionsgleiche Komponenten.

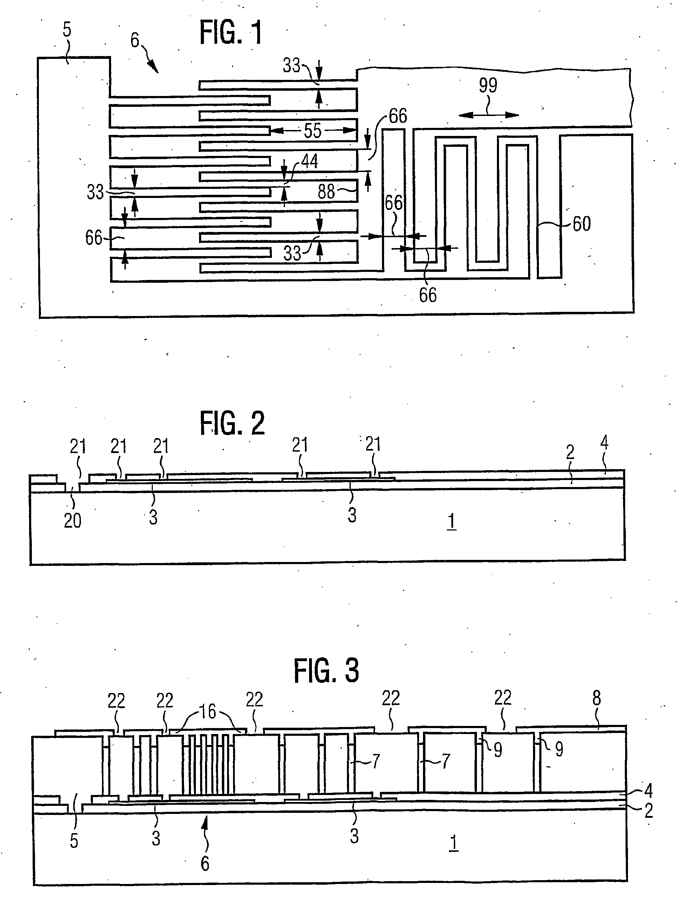

Fig. 1 zeigt eine schematische Oberansicht der ersten mikromechanischen Funktionsschicht zur Erläuterung eines Herstellungsverfahrens eines mikromechanischen Bauelements gemäß einer ersten Ausführungsform der vorliegenden Erfindung.

Bei der in Fig. 1 gezeigten ersten Ausführungsform wird in der mikromechanischen Funktionsschicht 5 eine Kammstruktur mit einem Kammantrieb in Schwingungsrichtung 99 mit folgenden Design-Eigenschaften vorgesehen.

Kein Abstand zwischen zwei Strukturelementen ist größer als der maximale Abstand 66, der durch den Refillprozess abgedeckt werden kann. Bei dem Beispiel beträgt dieser maximale Abstand ca. 5 µm. Dadurch lässt sich stets die maximale Auslenkung erreichen.

In der Kammstruktur ist die Summe aus der Breite 22 eines Kammzinkens und zwei Abständen 44 zum benachbarten Kammzinken kleiner oder gleich dem maximalen Abstand 66 (z.B. Kammzinkenbreite 2 µm + 2 x Abstand 1,5 µm = 5 µm).

Jede Kante 88 der beweglichen Sensorstruktur 6, die zur Schwingungsrichtung 99 senkrecht steht, ist mit einer transversalen Kammstruktur versehen.

Die transversalen Kammstrukturen werden bei diesem Beispiel als Antriebs- und Detektionsstrukturen für die Schwingungserzeugung der Sensorstruktur 6 verwendet werden. Die maximale Schwingungsamplitude 55 in Schwingungsrichtung 99 ist einfach per Design festlegbar.

Weiterhin ist bei der gefalteten Biegefeder 60 die maximale Schwinungsamplitude 55 durch die Anzahl der Faltungen erweitert, und zwar ist die maximale Schingungsamplitude 55 gleich der Anzahl der Faltungen (hier sechs) mal dem maximalen Abstand 66 bzw. der maximalen Grabenbreite.

Dieses Design ist im Übrigen auch auf rotatorisch schwingende Strukturen anwendbar, indem man gekrümmte transversale Kammstrukturen realisiert.

Fig. 2 zeigt eine schematische Querschnittsansicht zur Erläuterung des Herstellungsverfahrens eines mikromechanischen Bauelements gemäß der ersten Ausführungsform der vorliegenden Erfindung in einem ersten Prozessstadium.

In Fig. 2 bezeichnet 1 einen Silizium-Substratwafer, 2 ein unteres Oxid, 3 eine vergrabene Polysiliziumschicht, 4 ein Opferoxid, 20 ein Kontaktloch im unteren Oxid 2 und 21 Kontaktlöcher im Opferoxid 4.

Zur Herstellung der in Figur 2 gezeigten Struktur erfolgt zunächst eine ganzflächige Abscheidung des unteren Oxids 2 auf dem Silizium-Substratwafer 1. In einem folgenden Schritt wird Polysilizium abgeschieden und strukturiert, um Leiterbahnen in der vergrabenen Polysiliziumschicht 3 zu erzeugen.

Darauffolgend wird das Opferoxid 4 auf die gesamte Struktur ganzflächig aufgebracht, zum Beispiel durch ein LTO (Low Temperature Oxid)-Verfahren oder durch ein TEOS (Tetra-ethyl-Orthosilikat)-Verfahren. Anschließend werden die Kontaktlöcher 20 und 21 an den dafür vorgesehenen Stellen mittels üblicher Phototechniken und Ätztechniken geschaffen.

Fig. 3 zeigt eine schematische Querschnittsansicht des zur Erläuterung des Herstellungsverfahrens des mikromechanischen Bauelements gemäß der ersten Ausführungsform der vorliegenden Erfindung in einem zweiten Prozessstadium.

In Fig. 3 bezeichnen zusätzlich zu den bereits eingeführten Bezugszeichen 5 eine erste mikromechanische Funktionsschicht in Form einer Epitaxie-Polysiliziumschicht, 6 eine später beweglich zu machende Sensorstruktur (Kammstruktur), 7 Gräben in der ersten mikromechanischen Funktionsschicht 5, 8 ein erstes Verschlussoxid (LTO, TEOS o.ä.), 9 Pfropfen in den Gräben 7 bestehend aus dem Verschlussoxid 8, 16 Oxidverbindungsbereiche zum späteren Opferoxidätzen und 22 Kontaktlöcher im Verschlussoxid 8.

Zur Herstellung der in Figur 3 gezeigten Struktur erfolgt zunächst in bekannter Weise eine Abscheidung von Epitaxie-Polysilizium zur Bildung der ersten mikromechanischen Funktionsschicht 5, eine Strukturierung der mikromechanischen Funktionsschicht 5 zur Bildung der beweglich zu machenden Sensorstruktur 6 und der Gräben 7.

Hierauf erfolgt ein Refill-Prozess zum Verschließen der Gräben 7 mit dem Verschlussoxid 8 und anschließend optionellerweise eine Planarisierung. Obwohl nachstehend nicht explizit erwähnt, kann solch eine Planarisierung prinzipiell nach jeder ganzflächigen Schichtabscheidung vorgenommen werden.

Beim gezeigten Beispiel ist der Refill nicht vollständig, sondern deckt die darunter liegende Struktur nur nach oben hin zu 100% ab und sorgt ebenfalls für eine Abdichtung. Dies ist in Fig. 6 detaillierter gezeigt.

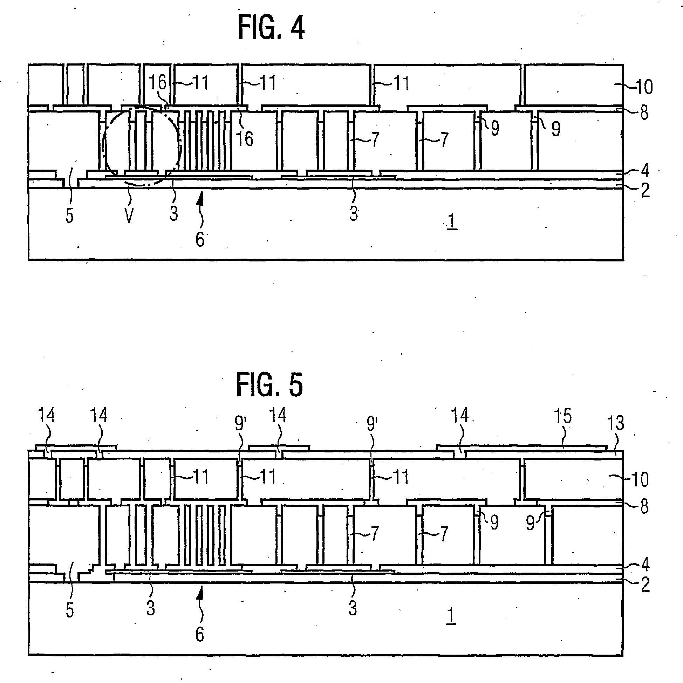

Es folgt ein Prozess zur Bildung der Kontaktlöcher 22 durch übliche Phototechniken und Ätztechniken. Diese Kontaktlöcher 22 dienen zur Verankerung der später aufzubringenden zweiten mikromechanischen Funktionsschicht 10 (vergleiche Figur 4) und zur Eingrenzung von den Oxidverbindungsbereichen 16 zum späteren Opferoxidätzen.

Fig. 4 zeigt eine schematische Querschnittsansicht zur Erläuterung des Herstellungsverfahrens des mikromechanischen Bauelements gemäß der ersten Ausführungsform der vorliegenden Erfindung in einem dritten Prozessstadium.

In Fig. 4 bezeichnen zusätzlich zu den bereits eingeführten Bezugszeichen 10 eine zweite mikromechanische Funktionsschicht in Form einer Epitaxie-Polysiliziumschicht und 11 Gräben in der zweiten mikromechanischen Funktionsschicht 10.

Zum Aufbau der in Figur 4 gezeigten Struktur wird die zweite mikromechanische Funktionsschicht 10 analog zur ersten mikromechanischen Funktionsschicht 5 als stabile Verschlussschicht für die darunterliegende Sensorstruktur 6 abgeschieden. Neben dieser Verschlussfunktion kann die zweite mikromechanische Funktionsschicht 10 natürlich auch zur Kontaktierung, als Zuleitung, als obere Elektrode usw. für das Bauelement dienen. Es folgen eine Strukturierung dieser Schicht 10 zur Herstellung der Gräben 11, welche später zusammen mit den Gräben 9 für das Opferoxidätzen benötigt werden.

Fig. 5 zeigt eine schematische Querschnittsansicht zur Erläuterung des Herstellungsverfahrens des mikromechanischen Bauelements gemäß der ersten Ausführungsform der vorliegenden Erfindung in einem vierten Prozessstadium.

In Figur 5 bezeichnen zusätzlich zu den bereits eingeführten Bezugszeichen 13 ein zweites Verschlussoxid (LTO, TEOS o.ä.), 14 ein Kontaktloch in dem Verschlussoxid 13, 15 eine Leiterbahnebene aus Aluminium, welche über die Kontaktlöcher 14 mit der zweiten mikromechanischen Funktionsschicht 10 verbunden ist.

Ausgehend von dem in Figur 4 gezeigten Prozeßstadium werden zum Erreichen des Prozeßstadiums nach Figur 5 folgende Schritte durchgeführt. Zunächst erfolgt ein Ätzen des Verschlußoxids 8 zum Entfernen der Oxidverbindungsbereiche 16 unter Verwendung der zweiten Gräben 11 als Ätzkanäle. Darauf erfolgt ein Ätzen der Opferschicht 4 unter Verwendung der durch das Entfernen der Verbindungsbereiche 16 miteinander verbundenen ersten und zweiten Gräben 7, 11 als Ätzkanäle. Ein langes Opferoxidätzen ist möglich, da noch kein Aluminium auf der Oberfläche vorhanden ist.

In einem darauffolgenden Prozeßschritt erfolgt ein zweiter Refill-Prozeß zur Bildung des zweiten Verschlußoxids 13, wobei diese Abscheidung ebenfalls keine konforme Abscheidung ist, sondern die Gräben 11 nur an ihrer Oberfläche verpfropft. Dies ist in Figur 6 näher illustriert. Der in der Sensorstruktur 6 eingeschlossene Innendruck bzw. die Innenatmosphäre sind abhängig von den Prozeßbedingungen beim Refill-Prozeß. Diese Parameter bestimmen z.B. die Dämpfung der Sensorstruktur.

Anschließend erfolgen eine Strukturierung des zweiten Verschlußoxids 13 zur Bildung der Kontaktlöcher 14 und eine Abscheidung und Strukturierung der Leiterbahnschicht 15 aus Aluminium.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Es können insbesondere beliebige mikromechanische Grundmäterialien, wie z.B. Germanium, verwendet werden, und nicht nur das exemplarisch angeführte Siliziumsubstrat.

Auch können beliebige Sensorstrukturen gebildet werden, und nicht nur der illustrierte Beschleunigungssensor.

Obwohl in den Figuren nicht dargestellt, können die Gräben 7 bzw. 11 nach oben verengt gestaltet sein, um die nicht-konforme Abscheidung der ersten bzw. zweiten Verschlußschicht 8, 13 zu fördern.

Es kann eine Variation der Schichtdicken der ersten und zweiten mikromechanischen Funktionsschicht 5, 10 durch den Epitaxie- und Planarisierungsprozeß in einfacher Weise vollzogen werden, da das Opferschichtätzen nicht von der Permeabilität der zweiten mikromechanischen Funktionsschicht abhängt.

Natürlich kann die Abfolge mikromechanische Funktionsschicht/Verschlußschicht mehrfach erfolgen, und man kann auch eine vergrabene Leiterbahn jeweils unter einer jeweiligen mikromechanischen Funktionsschicht oberhalb der darunter liegenden mikromechanischen Funktionsschicht vorsehen.

Schließlich können auch weitere Verdrahtungsebenen in Aluminium oder sonstigen geeigneten Metallen mit dazwischen liegendem dielektrischen aufgebracht werden.

Die optionelle Planarisierung der einzelnen Ebenen, zum Beispiel mittels chemisch-mechanischem Polieren, kann auch nur in einem einzigen Polierschritt erfolgen, vorzugsweise nur für die zweite Verschlußschicht.

## Patentansprüche

1. Verfahren zur Herstellung eines mikromechanischen Bauelementes mit den Schritten:
Bereitstellen eines Substrates (1);
Vorsehen einer ersten mikromechanischen Funktionsschicht (5) auf dem Substrat (1);
Strukturieren der ersten mikromechanischen Funktionsschicht (5) derart, dass sie eine beweglich zu machende Sensorstruktur (6) aufweist;
Vorsehen und Strukturieren einer ersten Verschlussschicht (8) auf der strukturierten ersten mikromechanischen Funktionsschicht (5);
Vorsehen und Strukturieren einer zweiten mikromechanischen Funktionsschicht (10) auf der ersten Verschlussschicht (8), welche zumindest eine Abdeckfunktion aufweist und zumindest teilweise in der ersten mikromechanischen Funktionsschicht (5) verankert wird;
Beweglichmachen der Sensorstruktur (6); und
Vorsehen einer zweiten Verschlussschicht (13) auf der zweiten mikromechanischen Funktionsschicht (10);
**gekennzeichnet durch** die Schritte
Ermitteln einer maximalen Grabenbreite (66), welche **durch** die erste Verschlussschicht (8) in Form von Pfropfen (9) verschließbar ist, welche die Grabenböden nicht erreichen; und
Versehen der Sensorstruktur (6) mit Gräben (7), deren Breite nicht größer ist als die ermittelte maximale Grabenbreite (66).

2. Verfahren nach Anspruch 1, **gekennzeichnet durch** den Schritt:
Vorsehen einer Kammstruktur mit ineinandergreifenden Kammzinken in der Sensorstruktur (6);
wobei die Summe der Breite (33) eines Kammzinkens und zweier Abstände (44) zum nächst benachbarten Kammzinken kleiner oder gleich der maximalen Grabenbreite (66) ausgelegt wird.

3. Verfahren nach Anspruch 1 oder 2, **gekennzeichnet durch** den Schritt:
Vorstehen einer gefalteten Biegefederstruktur in der Sensorstruktur (6);
wobei der Abstand der Faltungen gleich der maximalen Grabenbreite (66) ausgelegt wird, so dass die maximale Schwingungsamplitude (55) gleich der Anzahl der Faltungen mal der maximalen Grabenbreite (66) beträgt.

4. Verfahren nach Anspruch 1, 2 oder 3, **gekennzeichnet durch** die Schritte:
Vorsehen einer Opferschicht (4) auf dem Substrat (1); und
Ätzen der Opferschicht (4) und der ersten Verschlussschicht (8) zum Beweglichmachen der Sensorstruktur (6).

5. Verfahren nach Anspruch 4, **gekennzeichnet durch** die Schritte:
Strukturieren der ersten mikromechanischen Funktionsschicht (5) derart, dass sie bis zur Opferschicht (4) reichende erste Durchgänge (7) aufweist;
Strukturieren der zweiten mikromechanischen Funktionsschicht (10) derart, dass sie bis zur ersten Verschlussschicht (8) reichende zweite Durchgänge (11) aufweist, welche **durch** Verbindungsbereiche (16) der ersten Verschlussschicht (8) mit den ersten Durchgängen (7) verbunden sind;
Ätzen der ersten Verschlussschicht (8) zum Entfernen der Verbindungsbereiche (16) unter Verwendung der zweiten Durchgänge (11) als Ätzkanäle; und
Ätzen der Opferschicht (4) unter Verwendung der **durch** das Entfernen der Verbindungsbereiche (16) miteinander verbundenen ersten und zweiten Durchgänge (7, 11) als Ätzkanäle.

6. Verfahren nach einem der vorhergehenden Ansprüche, **dadurch gekennzeichnet, dass** eine vergrabene Polysiliziumschicht (3) unterhalb der ersten oder zweiten mikromechanischen Funktionsschicht (5, 10) vorgesehen wird.

7. Verfahren nach einem der vorhergehenden Ansprüche, **dadurch gekennzeichnet, dass** die erste und zweite Verschlussschicht (8, 13) wesentlich dünner als die erste und zweite mikromechanische Funktionsschicht (5, 10) gestaltet werden.

8. Verfahren nach einem vorhergehenden Ansprüche, **dadurch gekennzeichnet, dass** die erste und/oder zweite Verschlussschicht (8, 13) durch eine nicht-konforme Abscheidung derart vorgesehen werden, dass die ersten bzw. zweiten Durchgänge (7, 11) nur im oberen Bereich verpropft werden.

9. Verfahren nach einem der vorhergehenden Ansprüche 5 bis 8, **dadurch gekennzeichnet, dass** die ersten und/oder zweiten Durchgänge (7, 11) als Gräben oder Löcher gestaltet werden, die sich nach oben hin verengen.

10. Verfahren nach einem der vorhergehenden Ansprüche, **dadurch gekennzeichnet, dass** die erste und/oder zweite mikromechanische Funktionsschicht (5, 10) aus einem leitenden Material, vorzugsweise Polysilizium, hergestellt werden.

11. Verfahren nach einem der vorhergehenden Ansprüche, **dadurch gekennzeichnet, dass** die erste und/oder zweite Verschlussschicht (8, 13) aus einem dielektrischen Material, vorzugsweise Siliziumdioxid, hergestellt werden.

12. Verfahren nach einem der vorhergehenden Ansprüche, **dadurch gekennzeichnet, dass** auf der zweiten Verschlussschicht (13) eine oder mehrere Leiterbahnschichten (15), vorzugsweise aus Aluminium, vorgesehen werden.

13. Verfahren nach einem der vorhergehenden Ansprüche, **dadurch gekennzeichnet, dass** in die zweite mikromechanische Funktionsschicht (10) eine Leiterbahnstruktur integriert wird.

## Claims

1. Method for producing a micromechanical component having the following steps:
providing a substrate (1);
providing a first micromechanical functional layer (5) on the substrate (1);
patterning the first micromechanical functional layer (5) in such a way that it has a sensor structure (6) to be mobilized;
providing and patterning a first closure layer (8) on the patterned first micromechanical functional layer (5);
providing and patterning a second micromechanical functional layer (10) on the first closure layer (8), which has at least one covering function and is anchored at least partially in the first micromechanical functional layer (5);
mobilizing the sensor structure (6); and
providing a second closure layer (13) on the second micromechanical functional layer (10);
**characterized by** the following steps
determining a maximum trench width (66) which can be closed off by the first closure layer (8) in the form of plugs (9) which do not reach the trench bottoms; and
providing the sensor structure (6) with trenches (7) whose width is not greater than the maximum trench width (66) determined.

2. Method according to Claim 1, **characterized by** the following step:
providing a comb structure having intermeshing comb tines in the sensor structure (6);
wherein the sum of the width (33) of a comb tine and two distances (44) to the closest adjacent comb tine is designed to be less than or equal to the maximum trench width (66).

3. Method according to Claim 1 or 2, **characterized by** the following step:
providing a folded bending spring structure in the sensor structure (6);
wherein the distance between the folds is designed to be equal to the maximum trench width (66), such that the maximum oscillation amplitude (55) is equal to the number of folds times the maximum trench width (66).

4. Method according to Claim 1, 2 or 3, **characterized by** the following steps:
providing a sacrificial layer (4) on the substrate (1); and
etching the sacrificial layer (4) and the first closure layer (8) in order to mobilize the sensor structure (6).

5. Method according to Claim 4, **characterized by** the following steps:
patterning the first micromechanical functional layer (5) in such a way that it has first passages (7) reaching as far as the sacrificial layer (4);
patterning the second micromechanical functional layer (10) in such a way that it has second passages (11), which reach as far as the first closure layer (8) and are connected to the first passages (7) by connecting regions (16) of the first closure layer (8);
etching the first closure layer (8) in order to remove the connecting regions (16) using the second passages (11) as etching channels; and
etching the sacrificial layer (4) using the first and second passages (7, 11) - connected to one another by the removal of the connecting regions (16) - as etching channels.

6. Method according to any of the preceding claims, **characterized in that** a buried polysilicon layer (3) is provided below the first or second micromechanical functional layer (5, 10).

7. Method according to any of the preceding claims, **characterized in that** the first and second closure layers (8, 13) are made significantly thinner than the first and second micromechanical functional layers (5, 10).

8. Method according to any of the preceding claims, **characterized in that** the first and/or second closure layer (8, 13) are provided by means of a non-conformal deposition in such a way that the first and/or respectively second passages (7, 11) are stoppered only in the upper region.

9. Method according to any of the preceding Claims 5 to 8, **characterized in that** the first and/or second passages (7, 11) are configured as trenches or holes which narrow towards the top.

10. Method according to any of the preceding claims, **characterized in that** the first and/or the second micromechanical functional layer (5, 10) are produced from a conductive material, preferably polysilicon.

11. Method according to any of the preceding claims, **characterized in that** the first and/or the second closure layer (8, 13) are produced from a dielectric material, preferably silicon dioxide.

12. Method according to any of the preceding claims, **characterized in that** one or more interconnect layers (15), preferably made of aluminium, are provided on the second closure layer (13).

13. Method according to any of the preceding claims, **characterized in that** an interconnect structure is integrated into the second micromechanical functional layer (10).

## Revendications

1. Procédé de fabrication d'un composant micromécanique comprenant les étapes suivantes :
- fourniture d'un substrat (1),
- établissement d'une première couche fonctionnelle micromécanique (5) sur le substrat (1),
- mise en structure de la première couche fonctionnelle micromécanique (5) de façon qu'elle comporte une structure de capteur (6) que l'on peut rendre mobile,
- prévoir et structurer une première couche de fermeture(8) sur la première couche fonctionnelle micromécanique (5), mise en structure,
- prévoir et structurer une seconde couche fonctionnelle micromécanique (10) sur la première couche de fermeture (8) qui a au moins une fonction de couverture et est au moins partiellement accrochée dans la première couche fonctionnelle micromécanique (5),
- rendre mobile la structure de capteur 6, et
- prévoir une seconde couche de fermeture (13) sur la seconde couche fonctionnelle micromécanique (10),
**caractérisé par** les étapes suivantes :
- déterminer une largeur maximale de sillon (66) qui peut être fermé par la première couche de fermeture (8) sous la forme de bouchons (9), qui n'arrivent pas jusqu'au fond du sillon et
- munir la structure de capteur (6) de sillons (7) dont la largeur n'est pas supérieure à la largeur maximale de sillon (66) déterminée.

2. Procédé selon la revendication 1,
**caractérisé par** l'étape suivante :
prévoir une structure en forme de peigne avec des dents de peigne interdigités dans la structure de capteur (6) ;
la somme des largeurs (33) des dents de peigne et de deux intervalles (44) par rapport aux dents de peigne voisines est inférieure ou égale à la largeur maximale (66) de sillon.

3. Procédé selon la revendication 1 ou 2
**caractérisé par** l'étape suivante :
prévoir une structure de ressort de flexion, pliée, dans la structure de capteur (6),
la distance des plis étant égale à la largeur maximale de sillon (66) pour que l'amplitude maximale d'oscillation (55) soit égale au nombre de plis multiplié par la largeur maximale de sillon (66).

4. Procédé selon les revendications 1, 2 ou 3,
**caractérisé par** les étapes suivantes :
- prévoir une couche sacrificielle (4) sur le substrat (1) et
- graver la couche sacrificielle (4) et la première couche de fermeture (8) pour rendre mobile la structure de capteur (6).

5. Procédé selon la revendication 4,
**caractérisé par** les étapes suivantes :
- mise en structure de la première couche fonctionnelle micromécanique (5) de façon qu'elle comporte des premiers passages (7) arrivant jusqu'à la couche sacrificielle (4) ;
- mise en structure de la seconde couche fonctionnelle micromécanique (10) de façon qu'elle présente des seconds passages (11) qui arrivent jusqu'à la première couche de fermeture (8), ces passages étant reliés par des zones de liaison (16) de la première couche de fermeture (8) aux premiers passages (7) ;
- gravure de la première couche de fermeture (8) pour enlever les zones de liaison (16) en utilisant les seconds passages (11) comme canaux de gravure et
- réalisation de la gravure de la couche sacrificielle (4) en utilisant comme canaux de gravure les premiers et seconds passages (7, 11) reliés entre eux par l'enlèvement des zones de liaison (16).

6. Procédé selon l'une des revendications précédentes,
**caractérisé par**
une couche de poly-silicium (3), enfouie, en-dessous de la première ou de la seconde couche fonctionnelle micromécanique (5, 10).

7. Procédé selon l'une des revendications précédentes,
**caractérisé en ce que**
la première et la seconde couche de fermeture (8, 13) sont beaucoup plus minces que la première et la seconde couche fonctionnelle micromécanique (5, 10).

8. Procédé selon l'une des revendications précédentes,
**caractérisé en ce que**
la première et/ou la seconde couche de fermeture (8, 13) sont prévues par une découpe non-conforme de façon que les premiers et seconds passages (7, 11) ne sont bouchés que dans la zone supérieure.

9. Procédé selon l'une des revendications 5 à 8,
**caractérisé en ce que**
l'on forme les premiers et/ou les seconds passages (7, 11) sous la forme de sillons ou de trous qui vont en diminuant en remontant.

10. Procédé selon l'une des revendications précédentes,
**caractérisé en ce que**
l'on réalise la première et/ou la seconde couche micromécanique fonctionnelle (5, 10) en une matière conductrice, de préférence en poly-silicium.

11. Procédé selon l'une des revendications précédentes,
**caractérisé en ce qu'**
on réalise la première et/ou la seconde couche de fermeture (8, 13) en un matériau diélectrique, de préférence en dioxyde de silicium.

12. Procédé selon l'une des revendications précédentes,
**caractérisé en ce que**
l'on prévoit une ou plusieurs couches de chemins conducteurs (15) de préférence en aluminium, sur la seconde couche de fermeture (13).

13. Procédé selon l'une des revendications précédentes,
**caractérisé en ce que**
dans la seconde couche fonctionnelle micromécanique (10) on intègre une structure de chemins conducteurs.
